# EUROPEAN PATENT APPLICATION

(11) **EP 4 506 704 A1**
(43) Date of publication of application: **12.02.2025**
(21) Application number: 24152312.5
(22) Date of filing: 17.01.2024
(51) Int. Cl.: G01R 31/392, G01R 31/396, H02J 7/00, B60L 58/18, H01M 10/48

(54) **METHOD AND APPARATUS FOR DIAGNOSING BATTERY SYSTEM**

(30) Priority: 08.08.2023 KR 20230103346
(71) Applicant: Samsung SDI Co., Ltd., Yongin-si, Gyeonggi-do 17084 (KR)
(72) Inventor: Park, Joon Ho, Suwon-si, Gyeonggi-do 16678 (KR); Seo, Ye Chan, Suwon-si, Gyeonggi-do 16678 (KR); Kang, Chris Kyoung Min, Suwon-si, Gyeonggi-do 16678 (KR); Baek, Do Hyun, Suwon-si, Gyeonggi-do 16678 (KR); Ahn, Gi Jang, Suwon-si, Gyeonggi-do 16678 (KR)
(74) Representative: Gulde & Partner

(57) **Abstract**

Disclosed is a method for diagnosing a battery system (BAT) having a hierarchical structure including a lower-level battery device (LB) and a higher-level battery device (HB). The method includes: determining, by a processor (100), first and second charge/discharge test environments providing complementary characteristics for performance degradation of the higher-level battery device (HB) exhibits by performing a charge/discharge test with respect to the higher-level battery device (HB); performing, by the processor (100), a charge/discharge test with respect to the lower-level battery device (LB) under the first and second charge/discharge test environments to determine whether a test result matches the complementary characteristics under the first and second charge/discharge test environments; and deriving, by the processor (100), optimal operating conditions of the battery system (BAT) in which the complementary characteristics under the first and second charge/discharge test environments are removed, upon determining that the test result of the charge/discharge test with respect to the lower-level battery device (LB) matches the complementary characteristics under the first and second charge/discharge test environments.

## Description

### Field

Aspects of embodiments of the present disclosure relates to a method and apparatus for diagnosing a battery system.

### Description of the Related Art

Secondary batteries can be charged and discharged unlike a primary battery that cannot be charged. Low-capacity secondary batteries with a single battery cell packaged in a pack are used in small portable electronic devices, such as mobile phones and camcorders. In addition, high-capacity secondary battery modules with dozens of cell packs connected to each other are widely used as power sources of hybrid and electric vehicles.

Secondary batteries are packed into a higher-level battery with cells as a basic unit, such as a module, a pack, and a rack (for example, ESS), according to power required by products and the number of cells increases as the level of the battery becomes higher, thereby requiring different packing structures.

According to the structure of a battery at a higher level (for example, a pack or a rack) (hereinafter, higher-level battery device), batteries at a lower level (for example, a module or a cell) (hereinafter, lower-level battery devices) disposed therein are exposed to different environments, and performance of the higher-level battery device is determined by a lower-level battery device exposed to the most inferior environment.

The above information disclosed in this Background section is for enhancement of understanding of the background of the present disclosure, and therefore, it may contain information that does not constitute related (or prior) art.

### Summary of the Invention

Embodiments of the present disclosure provide a method and apparatus for diagnosing a battery system, such as a secondary battery, which derives optimal operating conditions of the battery system by diagnosing performance of the battery system through interconnection between a higher-level battery device and a lower-level battery device.

In accordance with one aspect of the present invention, there is provided a method for diagnosing a battery system having a hierarchical structure including a lower-level battery device and a higher-level battery device. The method includes: determining, by a processor, first and second charge/discharge test environments providing complementary characteristics for performance degradation of the higher-level battery device exhibits by performing a charge/discharge test with respect to the higher-level battery device; performing, by the processor, a charge/discharge test with respect to the lower-level battery device under the first and second charge/discharge test environments to determine whether a test result matches the complementary characteristics under the first and second charge/discharge test environments; and deriving, by the processor, optimal operating conditions of the battery system in which the complementary characteristics under the first and second charge/discharge test environments are removed, upon determining that the test result of the charge/discharge test with respect to the lower-level battery device matches the complementary characteristics under the first and second charge/discharge test environments.

In the step of determining first and second charge/discharge test environments, the processor may perform the charge/discharge test with respect to the higher-level battery device to collect resistance and capacity of the higher-level battery device and may identify the complementary characteristics for performance degradation of the higher-level battery device based on the collected resistance and capacity.

In the step of determining first and second charge/discharge test environments, the processor may determine the first and second charge/discharge test environments based on the complementary characteristics for performance degradation of the higher-level battery device, and resistance and a degree of capacity degradation of the higher-level battery device under the first charge/discharge testing environment may be higher than resistance and a degree of capacity degradation of the higher-level battery device under the second charge/discharge testing environment.

The first and second charge/discharge test environments may include electric current and temperature of the higher-level battery device and, in the step of deriving optimal operating conditions, the processor may derive the optimal operating conditions based on the electric current and temperature of the higher-level battery device under the second charge/discharge testing environment.

In the step of deriving optimal operating conditions, the processor may perform the charge/discharge test again with respect to the higher-level battery device plural times under the second charge/discharge test environment, and may derive the electric current and temperature of the higher-level battery device under the second charge/discharge testing environment as the optimal operating conditions, when each test result meets a first allowable condition previously defined under consideration of performance degradation of the higher-level battery device.

The lower-level battery device may include a plurality of battery units; and the method may further include: when the test result of the charge/discharge test with respect to the lower-level battery device does not match the complementary characteristics under the first and second charge/discharge test environments, performing, by the processor, the charge/discharge test with respect to the lower-level battery device under charge/discharge test conditions defining electric current and temperature of each of the plurality of battery units to determine first and second battery units exhibiting complementary characteristics for performance degradation among the plurality of battery units; changing, by the processor, the charge/discharge test conditions based on a charge/discharge test environment of each of the first and second battery units identified in the course of the charge/discharge test with respect to the lower-level battery device, followed by performing the charge/discharge test again with respect to the lower-level battery device under the changed charge/discharge test conditions; and analyzing, by the processor, a degree of degradation of the higher-level battery device after performing the charge/discharge test again.

In the step of determining first and second battery units, the processor may perform the charge/discharge test with respect to the lower-level battery device to collect resistance and capacity of the lower-level battery device and may identify complementary characteristics for performance degradation of the plurality of battery units based on the collected resistance and capacity.

In the step of determining first and second battery units, the processor may determine the first and second battery units exhibiting the complementary characteristics for performance degradation among the plurality of battery units, and resistance and a degree of capacity degradation of the first battery unit may be higher than resistance and a degree of capacity degradation of the second battery unit.

In the step of performing the charge/discharge test again, the processor may change the charge/discharge test conditions by setting electric current and temperature of the first battery unit defined under the charge/discharge test conditions as electric current and temperature of the second battery unit.

In the step of performing the charge/discharge test again, the processor may regulate a temperature of each of the battery units to a temperature of the changed charge/discharge test conditions by controlling a temperature regulator allocated to each of the battery units.

When the degree of degradation of the higher-level battery device does not meet a predefined second allowable condition, the processor may further perform again (i) the step of determining the first and second battery units, (ii) the step of performing the charge/discharge test again with respect to the lower-level battery device, and (iii) the step of analyzing the degree of degradation of the higher-level battery device.

When the degree of degradation of the higher-level battery device meets a predefined second allowable condition, the processor may derive the optimal operating conditions of the battery system based on the changed charge/discharge test conditions and battery feature information collected with respect to each of the plurality of battery units in the course of the charge/discharge test with respect to the lower-level battery device.

In the step of deriving optimal operating conditions, the processor may correct the electric current of each of the battery units defined under the changed charge/discharge test conditions based on the battery feature information and may derive the corrected electric current of each of the battery units and the temperature of each of the battery units defined under the changed charge/discharge test conditions as the optimal operating conditions.

The battery feature information may include resistance of each of the battery units and, in the step of deriving optimal operating conditions, the processor may correct the electric current of each of the battery units defined under the changed charge/discharge test conditions such that the electric current of each of the battery units decreases with increasing resistance of each of the battery units.

The battery feature information may further include swelling elongation of each of the battery units and, in the step of deriving optimal operating conditions, the processor may correct the electric current of each of the battery units defined under the changed charge/discharge test conditions so as to reduce the swelling elongation of each of the battery units.

The method may further include, operating, by the processor, the battery system under the derived optimal operating conditions.

In accordance with another aspect of the present invention, there is provided an apparatus for diagnosing a battery system having a hierarchical structure including a lower-level battery device and a higher-level battery device, the apparatus including a processor, wherein the processor performs: a charge/discharge test with respect to the higher-level battery device to determine first and second charge/discharge test environments providing complementary characteristics for performance degradation of the higher-level battery device exhibits, performs a charge/discharge test with respect to the lower-level battery device under the first and second charge/discharge test environments to determine whether a test result matches the complementary characteristics under the first and second charge/discharge test environments, and derives optimal operating conditions of the battery system in which the complementary characteristics under the first and second charge/discharge test environments are removed, upon determining that the test result of the charge/discharge test with respect to the lower-level battery device matches the complementary characteristics under the first and second charge/discharge test environments.

According to the present invention, consistency in diagnosis of performance of a battery system having a hierarchical structure can be secured by determining a plurality of charge/discharge test environments providing complementary characteristics for performance degradation through a charge/discharge test with respect to a higher-level battery device, performing a charge/discharge test with respect to a lower-level battery device under the charge/discharge test environments, and determining whether test results of the charge/discharge test with respect to the higher-level battery device and the lower-level battery device match the complementary characteristics, whereby optimal operating conditions of the entire battery system can be derived.

In addition, according to the present invention, when the test results of the charge/discharge test with respect to the higher-level battery device and the lower-level battery device do not match the complementary characteristics, performance diagnosis is performed for each of battery units constituting the higher-level battery device and test conditions are changed based on the test results, whereby a lower-level battery unit affecting degradation in performance of the higher-level battery device can be rapidly specified and the optimal operating conditions of the entire battery system can be derived.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### Brief Description of the Drawings

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a block diagram of an apparatus for diagnosing a battery system according to an exemplary embodiment of the present invention.
FIG. 2 and FIG. 3 are flowcharts illustrating a method for diagnosing a battery system according to exemplary embodiments of the present invention.

### Detailed Description of the Invention

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

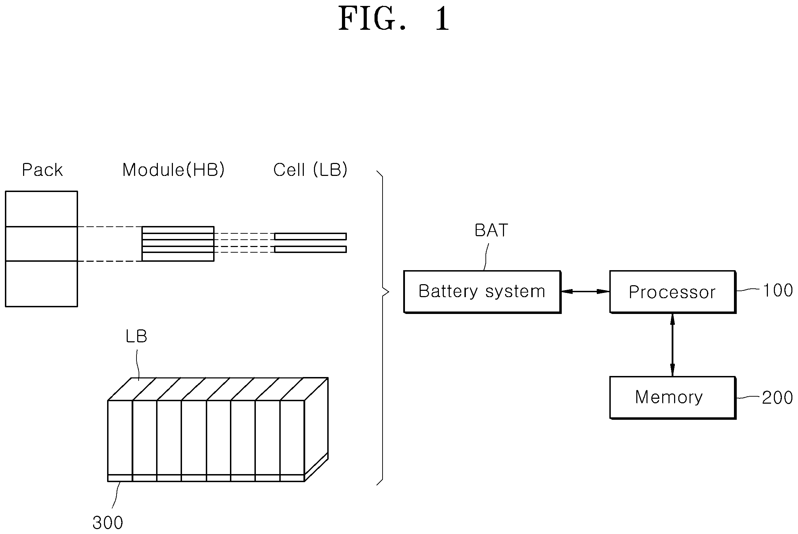

FIG. 1 is a block diagram of an apparatus for diagnosing a battery system according to an exemplary embodiment of the present invention.

In this embodiment, a battery system (BAT) may mean a secondary battery that is provided with a cathode plate and an anode plate to be charged/discharged through chemical reaction, and may be composed of a lithium (Li) battery, a sodium-sulfur (NaS) battery, a redox flow battery, a nickel-cadmium (Ni-Cd) battery, or a super capacitor, without being limited thereto. The battery system (BAT) may have a functionally and structurally hierarchical structure and may include a lower-level battery device LB and a higher-level battery device HB, which are classified according to the hierarchical structure. Examples of the "higher-level battery device/lower-level battery device" may include "module/cell", "pack/module" or "pack/cell". The lower-level battery device LB may be provided in plural to constitute the higher-level battery device HB and each lower-level battery device LB will be referred to as a battery unit for clarity of terminology. For ease of understanding of embodiments of the invention, the higher-level battery device HB will be described as corresponding to a module and the lower-level battery device LB will be described as corresponding to a cell.

The apparatus for diagnosing the battery system (hereinafter, referred to as "diagnosis apparatus") according to this embodiment may include a memory 200 and a processor 100, and may be implemented as a battery management system (BMS) that monitors current, voltage and temperature of the battery system (BAT) to control and manage the battery system (BAT) based on monitoring results. To assist in operation of such a battery management system, the diagnosis apparatus according to this embodiment may include a current sensor, a voltage sensor and a temperature, which are placed at predetermined locations to sense electric current, voltages and temperatures of the higher-level battery device HB and the lower-level battery device LB, respectively.

On the other hand, as described below, upon charging/discharging of the lower-level battery device LB, the temperature of each of battery units may be regulated. To this end, the diagnosis apparatus according to this embodiment may include a temperature regulator 300 provided to each of the battery units. Referring to FIG. 1, each of the battery units may be provided with the temperature regulator 300, which is disposed on one surface of the battery unit and operates to regulate the temperature of the battery unit in response to control of the processor 100. The temperature regulator 300 may be implemented by a thermoelectric element. Accordingly, the processor 100 may perform heating and cooling of the battery units by changing a direction of electric current applied to the thermoelectric element, and may control the degree of heating the battery unit and the degree of cooling the battery unit by adjusting the quantity of electric current applied to the thermoelectric element.

In the diagnosis apparatus, an initial test condition for an initial charge/discharge test of the higher-level battery device HB may be defined under the memory 200. The initial test condition may define electric current of the higher-level battery device HB applied in a plurality of cycles (1 cycle = charge and discharge once) for the charge/discharge test. Herein, the electric current is defined as a concept including charge current applied to the higher-level battery device HB or the lower-level battery device LB and discharge current drawn from the higher-level battery device HB and the lower-level battery device LB in the course of the charge/discharge test, and the charge current may be the same as or different from the discharge current. Under the initial test condition, the charge current applied to the higher-level battery device HB and the discharge current drawn from the higher-level battery device HB may be defined in each cycle. Further, the memory 200 may store at least one instruction executed by the processor 100. Such a memory 200 may be implemented by a volatile storage medium and/or a non-volatile storage medium, for example, a read only memory (ROM) and/or a random access memory (RAM).

In this embodiment, the processor 100 mainly serves to diagnose the battery system (BAT) and may be implemented by a central processing unit (CPU) or a system-on-chip (SoC). The processor 100 may execute an operating system or application to control a plurality of hardware or software components connected to the processor 100 and may perform various data processing and computations. The processor 100 may be configured to execute the at least one instruction stored in the memory 200 and to store data resulting from the execution in the memory 200.

Next, a method for diagnosing a battery system according to an exemplary embodiment will be described in detail based on operation of the processor 100.

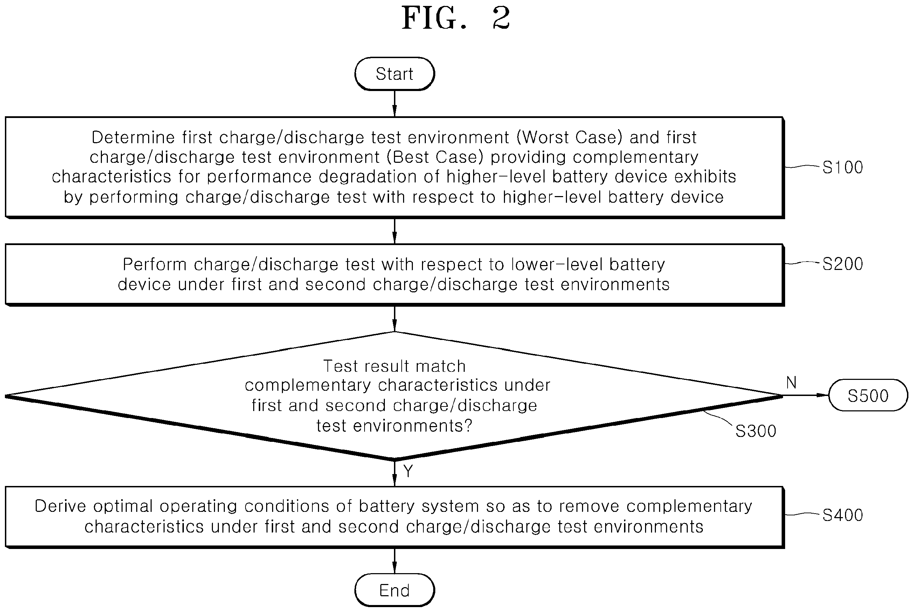

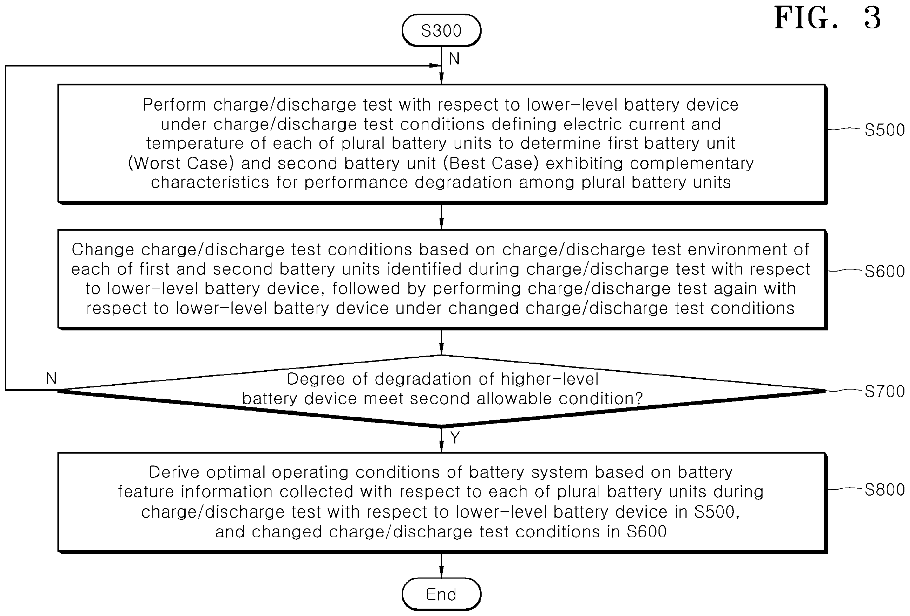

FIG. 2 and FIG. 3 are flowcharts illustrating a battery system diagnosing method according to an exemplary embodiment of the present invention.

Referring to FIG. 2, first, the processor 100 may determine first and second charge/discharge test environments providing complementary characteristics for performance degradation of the higher-level battery device HB by performing a plurality of cycles of charge/discharge tests with respect to the higher-level battery device HB under the initial test condition stored in the memory 200 (S 100).

Specifically, electric current for the charge/discharge test of the higher-level battery device HB may be defined in each cycle under the initial test condition and the processor 100 may perform the charge/discharge test with respect to the higher-level battery device HB by repeatedly applying (charging) electric current defined under the corresponding cycle to the higher-level battery device HB and drawing (discharging) electric current from the higher-level battery device HB in each cycle. In this process, resistance and capacity (capacity throughput, Ah) of the higher-level battery device HB and the temperature of the higher-level battery device HB are collected by the processor 100 in each cycle (resistance of the higher-level battery device HB may be obtained from the magnitude of current defined in each cycle and a voltage sensed by the voltage sensor).

The processor 100 may identify complementary characteristics for performance degradation of the higher-level battery device HB based on the resistance and capacity collected during the charge/discharge test with respect to the higher-level battery device HB. Here, performance degradation of the higher-level battery device HB may be indicated by resistance and the degree of capacity degradation (the degree of capacity degradation may be, for example, a discharge capacity based on a discharge current measured while the higher-level battery device HB is discharged from a fully charged state to a fully discharged state). Accordingly, the processor 100 may specify a charge/discharge test environment (Worst Case) in a cycle where the higher-level battery device HB exhibits the worst performance degradation, and may specify a charge/discharge test environment (Best Case) in a cycle where the higher-level battery device HB exhibits the lowest performance degradation. Assuming that the charge/discharge test environment corresponding to the 'Worst Case' is defined as a first charge/discharge test environment and the charge/discharge test environment corresponding to the 'Best Case' is defined as a second charge/discharge test environment, the higher-level battery device HB exhibits the complementary characteristics under each of the first and second charge/discharge test environments. That is, the resistance and the capacity degradation degree of the higher-level battery device HB in the first charge/discharge test environment are greater than the resistance and the capacity degradation degree of the higher-level battery device HB in the second charge/discharge test environment.

The first and second charge/discharge test environments may include electric current and temperature of the higher-level battery device HB. The electric current of the first charge/discharge test environment corresponds to the magnitude of electric current defined under the initial test condition in the cycle corresponding to the 'Worst Case' and the temperature of the first charge/discharge test environment corresponds to the temperature collected in the cycle corresponding to the 'Worst Case'. Similarly, the electric current of the second charge/discharge test environment corresponds to the magnitude of electric current defined under the initial test condition in the cycle corresponding to the 'Best Case' and the temperature of the second charge/discharge test environment corresponds to the temperature collected in the cycle corresponding to the 'Best Case'.

When the first charge/discharge test environment (Worst Case) and the second charge/discharge test environment (Best Case) are determined in step S 100, the processor 100 may perform a charge/discharge test with respect to the lower-level battery device LB under the first and second charge/discharge test environments (S200).

Specifically, the processor 100 may perform a first charge/discharge test with respect to the lower-level battery device LB under the first charge/discharge test environment by applying/drawing the electric current of the first charge/discharge test environment to/from each of the battery units and regulating the temperature of each of the battery units to the temperature of the first charge/discharge test environment through control of the temperature regulator 300. As a result of the first charge/discharge test, resistance and capacity of each of the battery units may be collected (resistance and capacity of each battery unit collected in the above process will be referred to as first data).

In addition, the processor 100 may perform a second charge/discharge test with respect to the lower-level battery device LB under the second charge/discharge test environment by applying/drawing the electric current of the second charge/discharge test environment to/from each of the battery units and regulating the temperature of each of the battery units to the temperature of the second charge/discharge test environment through control with respect to the temperature regulator 300. As a result of the second charge/discharge test, resistance and capacity of each of the battery units may be collected (resistance and capacity of each battery unit collected in the above process will be referred to as second data).

After step S200, the processor 100 may determine whether the test results in step S200 (that is, the first and second data) match the complementary characteristics under the first and second charge/discharge test environments (S300).

Specifically, in order to quantitatively determine whether the test results match the 'complementary characteristics', the processor 100 may first quantize the first and second data.

For example, the processor 100 may calculate an average of resistance values of the battery units (hereinafter, "first average resistance") and an average of capacity degradation degrees of the battery units (hereinafter, "first capacity degradation degree"), as included in the first data. Similarly, the processor 100 may calculate an average of resistance values of the battery units (hereinafter, "second average resistance") and an average of capacity degradation degrees of the battery units (hereinafter, "second capacity degradation degree"), as included in the second data.

The first average resistance and the first capacity degradation degree correspond to data under the first charge/discharge test environment corresponding to the 'Worst Case', and the second average resistance and the second capacity degradation degree correspond to data under the second charge/discharge test environment corresponding to the 'Best Case'. Accordingly, if the first average resistance and the first average capacity degradation degree are greater than the second average resistance and the second average capacity degradation degree, respectively, the processor 100 may determine that the test result of the charge/discharge test with respect to the lower-level battery device LB in step S200 matches the complementary characteristics under the first and second charge/discharge test environments identified in step S 100, and, if the first average resistance and the first average capacity degradation degree are lower than the second average resistance and the second average capacity degradation degree, the processor 100 may determine that the test result does not match the complementary characteristics.

In step S300, "match" means that the result of the charge/discharge test with respect to the higher-level battery device HB in step S 100 matches the result of the charge/discharge test with respect to the lower-level battery device LB in step S200, and thus means that, since an environmental difference between the higher-level battery device HB and the lower-level battery device LB is small, performance optimization of the entire battery system (BAT) can be achieved through performance optimization of the higher-level battery device HB. In this case, the processor 100 may derive an optimal operating condition for the battery system (BAT) without intervention at the lower-level battery device LB so as to remove the complementary characteristics under the first and second charge/discharge test environments identified in step S100 (S400). Removal of the complementary characteristics under the first and second charge/discharge test environments means that an operating environment of the higher-level battery device HB becomes consistent to allow removal of the 'Worst Case'.

In step S400, the processor 100 may derive the optimal operating condition based on the electric current and temperature of the higher-level battery device HB in the second charge/discharge test environment corresponding to the 'Best Case'. In this case, the processor 100 may derive the electric current and temperature of the higher-level battery device HB under the second charge/discharge test environment, as the optimal operating condition.

To improve reliability in deriving the optimal operating condition, the processor 100 may perform the charge/discharge test again with respect to the higher-level battery device HB under the second charge/discharge test environment plural times (in a plurality of cycles) and may derive the electric current and temperature of the higher-level battery device HB under the second charge/discharge test environment as the optimal operating condition only when each test result meets a first allowable condition preset in consideration of performance degradation of the higher-level battery device HB. The first allowable condition may correspond to, for example, a condition in which a ratio of the number of cycles, in which the resistance and the capacity degradation degree of the higher-level battery device HB are less than or equal to first and second reference values, to the total number of cycles is equal to or greater than a preset ratio (the first and second reference values may be preset by a designer as values indicating that performance of the higher-level battery device HB is not degraded) (the preset ratio may also be previously set based on a designer intention (for example, 80%)).

In step S300, upon determining that the result of the charge/discharge test with respect to the lower-level battery device LB does not match the complementary characteristics under the first and second charge/discharge test environments, this result means that the result of the charge/discharge test with respect to the higher-level battery device HB does not match the result of the charge/discharge test with respect to the lower-level battery device LB. Since this means that there is a need for intervention at the lower-level battery device LB for performance optimization of the battery system (BAT) due to a relatively large environmental difference between the higher-level battery device HB and the lower-level battery device LB, the processor 100 can derive the optimal operating condition for the entire battery system (BAT) by further performing the charge/discharge test with respect to the lower-level battery device LB.

Referring to FIG. 3, first, the processor 100 performs the charge/discharge test with respect to the lower-level battery device LB under charge/discharge test conditions defining electric current and temperature of each of the plurality of battery units to determine first and second battery units exhibiting complementary characteristics for performance degradation among the plurality of battery units (S500).

The charge/discharge test conditions used in step S500 may be electric current and temperature of the first charge/discharge test environment or electric current and temperature of the second charge/discharge test environment. In this case, it is desirable that the electric current and temperature of the second charge/discharge test environment corresponding to the 'Best Case' of the higher-level battery device HB be applied as the charge/discharge test conditions. Accordingly, in step S500, the processor 100 may perform the charge/discharge test with respect to the lower-level battery device LB under the charge/discharge test condition by applying/drawing the electric current of the second charge/discharge test environment to/from each of the battery units and regulating the temperature of each of the battery units to the temperature of the second charge/discharge test environment through control with respect to the temperature regulator 300.

As a result of the charge/discharge test with respect to the lower-level battery device LB, resistance and capacity of each of the battery units may be collected, and the processor 100 may identify complementary characteristics for performance degradation of the plurality of battery units based on the collected resistance and capacity. That is, based on the result of the charge/discharge test with respect to the lower-level battery device LB, the processor 100 may specify a battery unit exhibiting the worst performance degradation (Worst Case) and a battery unit exhibiting the lowest performance degradation (Best Case). Assuming that the battery unit corresponding to the 'Worst Case' is defined as a first battery unit and the battery unit corresponding to the 'Best Case' is defined as a second battery unit, the first and second battery units exhibit the complementary characteristics. That is, the resistance and the capacity degradation degree of the first battery unit are greater than the resistance and the capacity degradation degree of the second battery unit.

Thereafter, the processor 100 may change the charge/discharge test conditions based on the charge/discharge test environment of each of the first and second battery units identified in the course of the charge/discharge test with respect to the lower-level battery device LB, followed by performing the charge/discharge test again with respect to the lower-level battery device LB under the changed charge/discharge test conditions (S600). The charge/discharge test environment of each of the first and second battery units may include electric current and temperature.

In step S600, the processor 100 may change the charge/discharge test conditions by setting electric current and temperature of the first battery unit defined under the charge/discharge test conditions as electric current and temperature of the second battery unit. That is, the processor 100 may change the charge/discharge test conditions so as to remove the 'Worst Case' by setting electric current and temperature of the first battery unit corresponding to the 'Worst Case' as electric current and temperature of the second battery unit corresponding to the 'Best Case'. The remaining battery units (Normal Case) may maintain the electric current and the temperature previously defined under the charge/discharge test conditions. Thereafter, the processor 100 may perform the charge/discharge test with respect to the lower-level battery device LB again under the changed charge/discharge test conditions.

After performing the charge/discharge test again, the processor 100 may analyze the degree of degradation of the higher-level battery device HB (S700). That is, since change of the charge/discharge test conditions with respect to the lower-level battery device is performed for the purpose of improving performance of the higher-level battery device HB, it is desirable that suitability of the corresponding charge/discharge test conditions be determined with reference to performance of the higher-level battery device HB. Thus, the processor 100 may analyze the degree of degradation of the higher-level battery device HB to determine suitability of the charge/discharge test conditions, after performing the charge/discharge test again. The degree of degradation of the higher-level battery device HB may be a discharge capacity value depending on a discharge current measured while the higher-level battery device HB is discharged from a fully charged state to a fully discharged state, as described above, and a further charge/discharge test of the higher-level battery device HB to determine the discharge capacity value may also be performed. Accordingly, in step S700, the processor 100 may determine whether the degree of degradation of the higher-level battery device HB meets a predefined second allowable condition, for example, in which the degree of degradation of the higher-level battery device HB is less than or equal to a preset third reference.

In step S700, upon determining that the degree of degradation of the higher-level battery device HB does not meet the second allowable condition, the processor 100 may perform steps S500 to S700 again. Through this process, the charge/discharge test conditions may gradually approach the 'Best Case', and repetition of steps S500 to S700 may be stopped when the degree of degradation of the higher-level battery device HB meets the second allowable condition. If the degree of degradation of the battery device does not meet the second allowable condition even upon repetition of steps S500 to S700 N times (N is a natural number and may be a tuning parameter of a designer), a termination process may be performed to terminate the logic of this embodiment.

In step S700, upon determining that the degree of degradation of the higher-level battery device HB meets the second allowable condition, the processor 100 may derive optimal operating conditions of the battery system (BAT) based on battery feature information collected with respect to each of the plurality of battery units in the course of the charge/discharge test with respect to the lower-level battery device LB in step S500, and the charge/discharge test conditions changed in step S600 (S800). The battery feature information may include resistance and swelling elongation (that is, a difference in elongation between dimensions of three axes x, y and z upon charge and discharge) of each of the battery units (the swelling elongation may be calculated based on pressure values obtained by a pressure sensing seat (for example, an FPCB provided with a pressure sensor) provided to each of the battery units, as known in the art).

In the process of deriving the optimal operating conditions of the battery system (BAT) in step S800, the processor 100 may correct the electric current of each of the battery units, which is defined under the charge/discharge test conditions changed in step S600, based on the battery feature information, and may derive the corrected electric current of each of the battery units and the temperature of each of the battery units defined under the changed charge/discharge test conditions as the optimal operating conditions.

In this case, the processor 100 may correct the electric current of each of the battery units, which is defined under the changed charge/discharge test conditions, such that the electric current of each battery unit decreases with increasing resistance of each battery unit. Accordingly, charge/discharge current decreases upon operation of the corresponding battery unit, thereby reducing generation of heat due to high resistance.

Further, the processor 100 may correct the electric current of each of the battery units defined under the changed charge/discharge test conditions so as to reduce the swelling elongation of each of the battery units (for example, the processor 100 may correct the electric current of each of the battery units defined under the changed charge/discharge test conditions so as to reduce the swelling elongation of each of the battery units with increasing swelling elongation). Accordingly, the swelling elongation is reduced upon operation of the corresponding battery unit, thereby preventing generation of heat or fire from the battery system (BAT).

Finally, the processor 100 may operate the battery system (BAT) under the optimal operating conditions derived in step S400 or S800.

As such, according to the present invention, consistency in diagnosis of performance of a battery system having a hierarchical structure can be secured by determining a plurality of charge/discharge test environments providing complementary characteristics for performance degradation through a charge/discharge test with respect to a higher-level battery device, performing a charge/discharge test with respect to a lower-level battery device under the charge/discharge test environments, and determining whether test results of the charge/discharge test with respect to the higher-level battery device and the lower-level battery device match the complementary characteristics, whereby optimal operating conditions of the entire battery system can be derived .

In addition, according to the present invention, when the test results of the charge/discharge test with respect to the higher-level battery device and the lower-level battery device do not match the complementary characteristics, performance diagnosis is performed for each of battery units constituting the higher-level battery device and test conditions are changed based on the test results, whereby a lower-level battery unit affecting degradation in performance of the higher-level battery device can be rapidly specified and the optimal operating conditions of the entire battery system can be derived.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device, such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

## Claims

1. A method for diagnosing a battery system (BAT) having a hierarchical structure including a lower-level battery device (LB) and a higher-level battery device (HB), the method comprising:
determining, by a processor (100), first and second charge/discharge test environments providing complementary characteristics for performance degradation of the higher-level battery device (HB) exhibits by performing a charge/discharge test with respect to the higher-level battery device (HB);
performing, by the processor (100), a charge/discharge test with respect to the lower-level battery device (LB) under the first and second charge/discharge test environments to determine whether a test result matches the complementary characteristics under the first and second charge/discharge test environments; and
deriving, by the processor (100), optimal operating conditions of the battery system (BAT) in which the complementary characteristics under the first and second charge/discharge test environments are removed, upon determining that the test result of the charge/discharge test with respect to the lower-level battery device (LB) matches the complementary characteristics under the first and second charge/discharge test environments.

2. The method according to claim 1, wherein, in the step of determining first and second charge/discharge test environments, the processor (100) performs the charge/discharge test with respect to the higher-level battery device (HB) to collect resistance and capacity of the higher-level battery device (HB) and identifies the complementary characteristics for performance degradation of the higher-level battery device (HB) based on the collected resistance and capacity.

3. The method according to claim 1 or 2, wherein, in the step of determining first and second charge/discharge test environments, the processor (100) determines the first and second charge/discharge test environments based on the complementary characteristics for performance degradation of the higher-level battery device (HB), and resistance and a degree of capacity degradation of the higher-level battery device (HB) under the first charge/discharge testing environment are higher than resistance and a degree of capacity degradation of the higher-level battery device (HB) under the second charge/discharge testing environment.

4. The method according to any one of the preceding claims, wherein the first and second charge/discharge test environments comprise electric current and temperature of the higher-level battery device (HB) and, in the step of deriving optimal operating conditions, the processor (100) derives the optimal operating conditions based on the electric current and temperature of the higher-level battery device (HB) under the second charge/discharge testing environment.

5. The method according to any one of the preceding claims, wherein, in the step of deriving optimal operating conditions, the processor (100) performs the charge/discharge test again with respect to the higher-level battery device (HB) plural times under the second charge/discharge test environment and derives the electric current and temperature of the higher-level battery device (HB) under the second charge/discharge testing environment as the optimal operating conditions, when each test result meets a first allowable condition previously defined under consideration of performance degradation of the higher-level battery device (HB).

6. The method according to any one of the preceding claims, wherein the lower-level battery device (LB) comprises a plurality of battery units,
the method further comprising: when the test result of the charge/discharge test with respect to the lower-level battery device (LB) does not match the complementary characteristics under the first and second charge/discharge test environments,
performing, by the processor (100), the charge/discharge test with respect to the lower-level battery device (LB) under charge/discharge test conditions defining electric current and temperature of each of the plurality of battery units to determine first and second battery units exhibiting complementary characteristics for performance degradation among the plurality of battery units;
changing, by the processor (100), the charge/discharge test conditions based on a charge/discharge test environment of each of the first and second battery units identified in the course of the charge/discharge test with respect to the lower-level battery device (LB), followed by performing the charge/discharge test again with respect to the lower-level battery device (LB) under the changed charge/discharge test conditions; and
analyzing, by the processor (100), a degree of degradation of the higher-level battery device (HB) after performing the charge/discharge test again.

7. The method according to claim 6, wherein, in the step of determining first and second battery units, the processor (100) performs the charge/discharge test with respect to the lower-level battery device (LB) to collect resistance and capacity of the lower-level battery device (LB) and identifies complementary characteristics for performance degradation of the plurality of battery units based on the collected resistance and capacity.

8. The method according to claim 6 or 7, wherein, in the step of determining first and second battery units, the processor (100) determines the first and second battery units exhibiting the complementary characteristics for performance degradation among the plurality of battery units, and resistance and a degree of capacity degradation of the first battery unit are higher than resistance and a degree of capacity degradation of the second battery unit.

9. The method according to any one of claims 6 to 8, wherein, in the step of performing the charge/discharge test again, the processor (100) changes the charge/discharge test conditions by setting electric current and temperature of the first battery unit defined under the charge/discharge test conditions as electric current and temperature of the second battery unit.

10. The method according to any one of claims 6 to 9, wherein, in the step of performing the charge/discharge test again, the processor (100) regulates a temperature of each of the battery units to a temperature of the changed charge/discharge test conditions by controlling a temperature regulator (300) allocated to each of the battery units.

11. The method according to any one of claims 6 to 10, wherein, when the degree of degradation of the higher-level battery device (HB) does not meet a predefined second allowable condition, the processor (100) further performs again (i) the step of determining the first and second battery units, (ii) the step of performing the charge/discharge test again with respect to the lower-level battery device (LB), and (iii) the step of analyzing the degree of degradation of the higher-level battery device (HB).

12. The method according to any one of claims 6 to 11, wherein, when the degree of degradation of the higher-level battery device (HB) meets a predefined second allowable condition, the processor (100) derives optimal operating conditions of the battery system (BAT) based on the changed charge/discharge test conditions and battery feature information collected with respect to each of the plurality of battery units in the course of the charge/discharge test with respect to the lower-level battery device (LB).

13. The method according to claim 12, wherein, in the step of deriving optimal operating conditions, the processor (100) corrects the electric current of each of the battery units defined under the changed charge/discharge test conditions based on the battery feature information and derives the corrected electric current of each of the battery units and the temperature of each of the battery units defined under the changed charge/discharge test conditions as the optimal operating conditions.

14. The method according to claim 12 or 13, wherein the battery feature information comprises resistance of each of the battery units and swelling elongation of each of the battery units, and
in the step of deriving optimal operating conditions, the processor (100) is configured to
correct the electric current of each of the battery units defined under the changed charge/discharge test conditions such that the electric current of each of the battery units decreases with increasing resistance of each of the battery units, and
correct the electric current of each of the battery units defined under the changed charge/discharge test conditions so as to reduce the swelling elongation of each of the battery units.

15. An apparatus for diagnosing a battery system (BAT) having a hierarchical structure including a lower-level battery device (LB) and a higher-level battery device (HB), the apparatus comprising a processor (100),
wherein the processor (100) performs a charge/discharge test with respect to the higher-level battery device (HB) to determine first and second charge/discharge test environments providing complementary characteristics for performance degradation of the higher-level battery device (HB) exhibits, performs a charge/discharge test with respect to the lower-level battery device (LB) under the first and second charge/discharge test environments to determine whether a test result matches the complementary characteristics under the first and second charge/discharge test environments, and derives optimal operating conditions of the battery system (BAT) in which the complementary characteristics under the first and second charge/discharge test environments are removed, upon determining that the test result of the charge/discharge test with respect to the lower-level battery device (LB) matches the complementary characteristics under the first and second charge/discharge test environments.
